# EUROPEAN PATENT APPLICATION

(11) **EP 4 550 981 A1**
(43) Date of publication of application: **07.05.2025**
(21) Application number: 24202304.2
(22) Date of filing: 24.09.2024
(51) Int. Cl.: H10F 10/166, H10F 77/20, H10F 77/30

(54) **TRANSPARENT CONDUCTIVE CONTACT PASSIVATION HETEROJUNCTION SOLAR CELL AND CELL COMPONENT**

(30) Priority: 30.10.2023 CN 202311429073
(71) Applicant: Trina Solar Co., Ltd, Changzhou, Jiangsu 213031 (CN)
(72) Inventor: CHEN, Daming, Changzhou, 213031 (CN); WANG, Yao, Changzhou, 213031 (CN); YANG, Guangtao, Changzhou, 213031 (CN); CHEN, Yifeng, Changzhou, 213031 (CN)
(74) Representative: Nederlandsch Octrooibureau

(57) **Abstract**

The present application provides a transparent conductive contact passivation heterojunction solar cell and a cell component, the heterojunction solar cell comprises a silicon substrate, a tunneling layer, a first transparent conductive film layer and an anti-reflection layer, wherein: the silicon substrate has a first surface and a second surface opposite to each other, and the first surface is closer to a light-facing side of the heterojunction solar cell than the second surface; the tunneling layer, the first transparent conductive film layer and the anti-reflection layer are located on the first surface in sequence. The heterojunction solar cell and cell component provided by this application can increase the short-circuit current of the heterojunction solar cell, improve the efficiency of the solar cell, and achieve a better passivation effect overall.

## Description

### Technical Field

The present application mainly relates to the field of photovoltaic cell technology, and in particular to a transparent conductive contact passivation heterojunction solar cell and a cell component.

### Background

According to industry forecasts, heterojunction solar cells are expected to become the next generation of mainstream technology. Current heterojunctions use intrinsic amorphous silicon/doped amorphous silicon (or microcrystalline silicon) to form the emitter and surface field, which have excellent surface passivation properties. Companies in industry research institutions are working to improve efficiency and reduce costs of heterojunction solar cells, and have produced many improvement plans, such as microcrystalline silicon technology, high carrier mobility and low-doping transparent conductive film materials, etc. Heterojunction solar cells have broad application prospects and are widely used in household rooftops, industrial and commercial rooftops, and large ground power stations. How to continuously optimize the performance of heterojunction solar cells is a topic that needs continuous improvement in this field.

### Summary

The technical problem to be solved by the present invention is to provide a transparent conductive contact passivation heterojunction solar cell and a cell component, which can increase the short-circuit current of the heterojunction solar cell, improve the efficiency of the solar cell, and achieve a better passivation effect overall.

In order to solve the above technical problems, the present application provides a transparent conductive contact passivation heterojunction solar cell, which comprises a silicon substrate, a tunneling layer, a first transparent conductive film layer and an anti-reflection layer, wherein: the silicon substrate has a first surface and a second surface opposite to each other, and the first surface is closer to a light-facing side of the heterojunction solar cell than the second surface; the tunneling layer, the first transparent conductive film layer and the anti-reflection layer are located on the first surface in sequence.

Optionally, the silicon substrate's conductivity type is N type.

Optionally, the tunneling layer includes silicon oxide.

Optionally, the thickness of the tunneling layer is 0.5nm-3nm.

Optionally, the anti-reflection layer is an aluminum oxide layer, or includes a single layer film or a stacked film composed of aluminum oxide, silicon nitride, silicon oxide and/or silicon oxynitride.

Optionally, a thickness of the anti-reflection layer is 1nm~100nm.

Optionally, the transparent conductive contact passivation heterojunction solar cell further comprises a first electrode located on the light-facing side, the first electrode passing through the anti-reflection layer and contacting the first transparent conductive film layer.

Optionally, transparent conductive contact passivation heterojunction solar cell further comprises an intrinsic amorphous silicon layer, a doped amorphous silicon layer and a second transparent conductive film layer, which locate in sequence on the second surface.

Optionally, transparent conductive contact passivation heterojunction solar cell further comprises a second electrode in contact with the second transparent conductive film layer.

Optionally, the first transparent conductive film layer includes aluminum-doped zinc oxide.

Optionally, a thickness of the first transparent conductive film layer is 1nm~80nm.

In order to solve the above technical problems, the present invention also provides a cell component, which comprises a plurality of heterojunction solar cells as described above connected in series and/or in parallel.

Compared with the existing technology, this application uses a tunneling layer/transparent conductive film layer/anti-reflection film structure on the first surface of the cell to replace the conventional selection of intrinsic amorphous silicon layer/doped amorphous silicon layer, which can increase the short-circuit current of heterojunction solar cells, improve the efficiency of solar cells, reduce the single-line investment of heterojunction solar cells, and achieve a better passivation effect overall.

### Brief Description of the Drawings

The drawings are included to provide a further understanding of the present application, and they are included and constitute a part of the present application, the drawings show the embodiments of the present application, and serving to explain the principles of the present application together with the description. In the drawings:

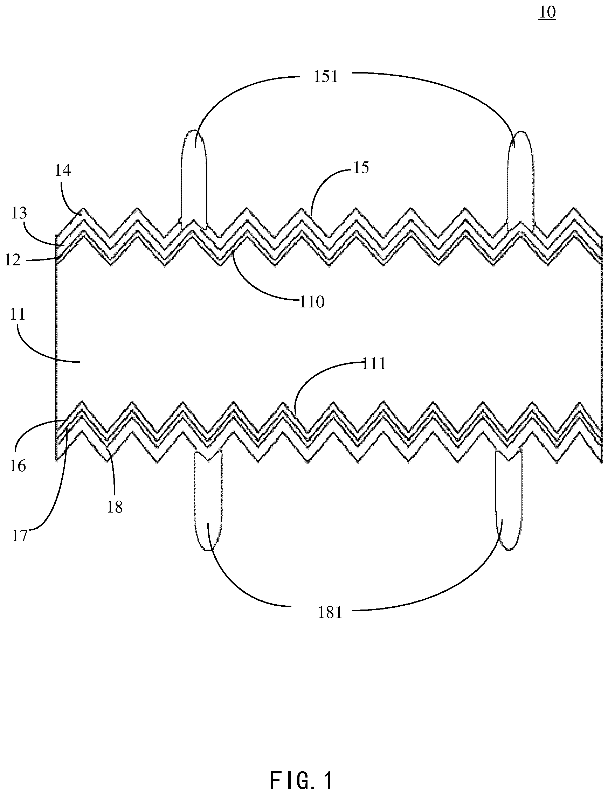

FIG. 1 is a schematic structural diagram of a heterojunction solar cell with transparent conductive contact passivation according to an embodiment of the present application.

### Preferred Embodiment of the Present Invention

In order to illustrate the technical solutions in the embodiments of the present application more clearly, the drawings that need to be used in the description of the embodiments will be briefly introduced below. Obviously, the drawings in the following description are only some embodiments of the present application, and for those skilled in the art, other drawings can also be obtained based on these drawings without creative effort.

As indicated in this application and claims, the terms "a", "an", "a kind of" and/or "the" do not specifically refer to the singular and may include the plural unless the context clearly indicates an exception. Generally speaking, the terms "comprising" and "including" only suggest the inclusion of clearly identified steps and elements, and these steps and elements do not constitute an exclusive list, and the method or device may also contain other steps or elements.

The relative arrangements of components and steps, numerical expressions and numerical values set forth in these embodiments do not limit the scope of the present application unless specifically stated otherwise. At the same time, it should be understood that, for the convenience of description, the sizes of the various parts shown in the drawings are not drawn according to the actual proportional relationship. Techniques, methods and devices known to those of ordinary skill in the relevant art may not be discussed in detail, but where appropriate, such techniques, methods and devices should be considered part of the authorized specification. In all embodiments shown and discussed herein, any specific values should be construed as illustrative only, and not as limiting. Therefore, other examples of the exemplary embodiment may have different values. It should be noted that like numerals and letters denote like items in the following figures, therefore, once an item is defined in one figure, it does not require further discussion in subsequent drawings.

In the description of the present application, it should be understood that orientation words such as "front, back, up, down, left, right", " landscape, portrait, vertical, horizontal" and "top, bottom" etc. indicating the orientation or positional relationship is generally based on the orientation or positional relationship shown in the drawings, only for the convenience of describing the application and simplifying the description, in the absence of a contrary statement, these orientation words do not indicate or imply that the device or element referred to must have a specific orientation or be constructed and operated in a specific orientation, and therefore cannot be construed as limiting the scope of protection of this application; the orientation words "inside and outside" refer to inside and outside relative to the outline of each part itself.

For the convenience of description, spatially relative terms may be used here, such as "on ...", "over ...", "on the upper surface of ...", "above", etc., to describe the spatial positional relationship between one device or feature and other devices or features. It will be understood that, in addition to the orientation depicted in the drawings, the spatially relative terms are intended to encompass different orientations of the device in use or operation. For example, if the device in the drawings is turned over, devices described as "on other devices or configurations " or "above other devices or configurations" would then be oriented "beneath other devices or configurations " or "under other devices or configurations ". Thus, the exemplary term "above" can encompass both an orientation of "above" and "beneath". The device may be otherwise oriented (rotated 90 degrees or at other orientations), and making a corresponding explanation for the space relative description used here.

In addition, it should be noted that the use of words such as "first" and "second" to define components is only for the convenience of distinguishing corresponding components, unless otherwise stated, the above words have no special meanings, and therefore cannot be construed as limiting the protection scope of the present application. In addition, although the terms used in this application are selected from well-known and commonly used terms, some terms mentioned in the specification of this application may be selected by the applicant according to his or her judgment, and their detailed meanings are listed in this article described in the relevant section of the description. Furthermore, it is required that this application be understood not only by the actual terms used, but also by the meaning implied by each term.

The present application shows a schematic structural diagram of a transparent conductive contact passivated heterojunction solar cell 10 (hereinafter referred to as the solar cell 10) with reference to FIG. 1. The solar cell 10 includes a silicon substrate 11, a tunneling layer 12, a first transparent conductive film layer 13 and an anti-reflection layer 14. Specifically, the type of silicon substrate 11 can be n-type or p-type, and in this embodiment, an n-type silicon substrate is preferred, which has the advantages of high minority carrier lifetime and smaller attenuation. The silicon substrate 11 has a first surface 110 and a second surface 111 opposite to each other, wherein, the first surface 110 is closer to a light-facing side 15 of the solar cell 10 than the second surface 111.

In this embodiment, the tunneling layer 12, the first transparent conductive film layer 13 and the anti-reflection layer 14 are located on the first surface 110 in sequence, that is, the stacked structure formed in sequence is on side of the light-facing surface 15.

Specifically, the tunneling layer 12 is located at the position of the first surface 110 farthest away from the light-facing surface 15, that is, the position closest to the substrate 11. In the present application, the tunneling layer 12 is preferably made of silicon oxide, and its thickness range is preferably set to 0.5nm-3nm, and more preferably can be designed to have a thickness of 1.2nm~1.6nm, especially 1.4nm. Compared with traditional heterojunction cells, the structure in which the solar cell 10 in this embodiment uses a tunneling layer instead of the intrinsic amorphous silicon layer can enhance the optical performance and thereby achieve a better passivation effect.

Furthermore, the first transparent conductive film layer 13 is located on the tunneling layer 12. In this embodiment, aluminum-doped zinc oxide is preferably selected as the material of the first transparent conductive film layer 13, and its thickness ranges from 1nm to 80 nm. Aluminum-doped zinc oxide has the functions of passivation, transparency, and conductivity at the same time, and can achieve better passivation effect.

Finally, the anti-reflection layer 14 is located on the first transparent conductive film layer 13, and the upper surface of the anti-reflection layer 14 forms the light-facing surface 15. In this embodiment, the anti-reflection layer 14 is preferably an aluminum oxide layer, or includes a single layer film or a stacked film composed of aluminum oxide, silicon nitride, silicon oxide and/or silicon oxynitride, and its thickness ranges from 1nm to 100 nm.

The structure of the side of light-facing 15 of the solar cell 10 has been introduced previously, and the structure of the other side (i.e., the backlight side) will be introduced below with reference to FIG. 1. According to FIG. 1, an intrinsic amorphous silicon layer 16, a doped amorphous silicon layer 17 and a second transparent conductive film layer 18 are located in sequence on the second surface 111. Specifically, the intrinsic amorphous silicon layer 17 includes an undoped amorphous silicon thin film material. The doped amorphous silicon layer 17 may be p-type amorphous silicon or p-type microcrystalline silicon. The second transparent conductive film layer 18 includes ITO or other transparent conductive film materials, and its material may be different from or the same as the first transparent conductive film layer.

On the other hand, in this embodiment, the solar cell 10 further includes a first electrode 120 and a second electrode 121. Wherein the first electrode 151 is located on the light-facing surface 15, and the first electrode 151 passes through the anti-reflection layer 14 and contacts the first transparent conductive film layer 13. On the other side of the solar cell 10 away from the light-facing surface 15, the second electrode 120 contacts the second transparent conductive film layer 18.

In this embodiment, the tunneling layer 12, the first transparent conductive film layer 13 and the anti-reflection layer 14 are combined on the light-facing surface 15 side of the solar cell (which can also be understood as the front surface of the solar cell 10), the three-layer structure significantly improves the passivation effect of heterojunction cells and overcomes the problem of low short-circuit current of solar cells caused by the light absorption of amorphous silicon/microcrystalline silicon on the front surface of traditional heterojunction cells.

Another aspect of the present application also provides a cell component, which comprises a plurality of heterojunction solar cells (for example, the solar cell 10) proposed in the present application that are connected in series and/or in parallel.

The combination of materials on the front surface of the structure designed in this patent is different from traditional heterojunction cells, and it particularly emphasizes arranging the tunneling layer, the first transparent conductive film layer and the anti-reflection layer in close proximity to each other, the aluminum oxide is placed in the anti-reflection layer preferably, and the anti-reflection layer containing aluminum oxide is in close contact with the first transparent conductive film layer containing aluminum-doped zinc oxide, which can achieve a better passivation effect compared to the existing battery structure.

The basic concepts have been described above, obviously, for those skilled in the art, the above disclosure of the invention is only an example, and does not constitute a limitation to the present application. Although not expressly stated here, various modifications, improvements and amendments to this application may be made by those skilled in the art. Such modifications, improvements, and amendments are suggested in this application, so such modifications, improvements, and amendments still belong to the spirit and scope of the exemplary embodiments of this application.

Meanwhile, the present application uses specific words to describe the embodiments of the present application. For example, "one embodiment", "an embodiment", and/or "some embodiments" refer to a certain feature, structure or characteristic related to at least one embodiment of the present application. Therefore, it should be emphasized and noted that two or more references to "one embodiment" or "an embodiment" or "an alternative embodiment" in different places in this specification do not necessarily refer to the same embodiment. In addition, certain features, structures or characteristics of one or more embodiments of the present application may be properly combined.

In the same way, it should be noted that in order to simplify the expression disclosed in the present application and help the understanding of one or more embodiments of the invention, in the foregoing description of the embodiments of the present application, sometimes multiple features are combined into one embodiment, drawings or descriptions thereof. However, this method of disclosure does not imply that the subject matter of the application requires more features than are recited in the claims. Indeed, embodiment features are less than all features of a single foregoing disclosed embodiment.

In some embodiments, numbers describing the quantity of components and attributes are used, it should be understood that such numbers used in the description of the embodiments use the modifiers "about", "approximately" or "substantially" in some examples. Unless otherwise stated, "about", "approximately" or "substantially" indicates that the stated figure allows for a variation of ±20%. Accordingly, in some embodiments, the numerical parameters used in the specification and claims are approximations that can vary depending upon the desired characteristics of individual embodiments. In some embodiments, numerical parameters should take into account the specified significant digits and adopt the general digit reservation method. Although the numerical ranges and parameters used in some embodiments of the present application to confirm the breadth of the scope are approximate values, in specific embodiments, such numerical values are set as precisely as practicable.

Although the present application has been described with reference to the current specific embodiments, those of ordinary skill in the art should recognize that the above embodiments are only used to illustrate the present application, and various equivalent changes or substitutions can also be made without departing from the spirit of the present application, therefore, as long as the changes and modifications to the above-mentioned embodiments are within the spirit of the present application, they will all fall within the scope of the claims of the present application.

## Claims

1. A transparent conductive contact passivation heterojunction solar cell, **characterized by** comprising a silicon substrate, a tunneling layer, a first transparent conductive film layer and an anti-reflection layer, wherein:
the silicon substrate has a first surface and a second surface opposite to each other, and the first surface is closer to a light-facing side of the heterojunction solar cell than the second surface;
the tunneling layer, the first transparent conductive film layer and the anti-reflection layer are located on the first surface in sequence.

2. The heterojunction solar cell according to claim 1, **characterized in that** the silicon substrate's conductivity type is N type.

3. The heterojunction solar cell according to claim 1, **characterized in that** the tunneling layer includes silicon oxide.

4. The heterojunction solar cell according to claim 3, **characterized in that** the thickness of the tunneling layer is 0.5nm-3nm.

5. The heterojunction solar cell according to claim 1, **characterized in that** the anti-reflection layer is an aluminum oxide layer, or includes a single layer film or a stacked film composed of aluminum oxide, silicon nitride, silicon oxide and/or silicon oxynitride.

6. The heterojunction solar cell according to claim 5, **characterized in that** a thickness of the anti-reflection layer is 1nm~100nm.

7. The heterojunction solar cell according to claim 1, **characterized by** further comprising a first electrode located on the light-facing side, the first electrode passing through the anti-reflection layer and contacting the first transparent conductive film layer.

8. The heterojunction solar cell according to claim 1, **characterized by** further comprising an intrinsic amorphous silicon layer, a doped amorphous silicon layer and a second transparent conductive film layer, which locate in sequence on the second surface.

9. The heterojunction solar cell according to claim 8, **characterized by** further comprising a second electrode in contact with the second transparent conductive film layer.

10. The heterojunction solar cell according to any one of claims 1-9, **characterized in that** the first transparent conductive film layer includes aluminum-doped zinc oxide.

11. The heterojunction solar cell according to claim 10, **characterized in that** a thickness of the first transparent conductive film layer is 1nm~80nm.

12. A cell component, **characterized by** comprising a plurality of heterojunction solar cells according to any one of claims 1~11 connected in series and/or in parallel.
